# EUROPÄISCHE PATENTSCHRIFT

(11) **EP 0 869 615 B1**
(45) Veröffentlichungstag und Bekanntmachung des Hinweises auf die Patenterteilung: **20.02.2002**
(21) Anmeldenummer: 98105130.3
(22) Anmeldetag: 20.03.1998
(51) Int. Cl.: H03K 19/00, H03K 19/0185

(54) **Eingangsverstärker mit einseitiger Versorgungsstromabschaltung für Eingangssignale mit steilen Flanken**
Input amplifier having current cut-off from the supply rail or to the ground for input signals having steep edges
Amplificateur d'entrée pour des signaux à front raide auquel le courant vers la masse ou venant de l'alimentation est interrompu

(30) Priorität: 03.04.1997 DE 19713833
(43) Veröffentlichungstag der Anmeldung: 07.10.1998
(73) Patentinhaber: Infineon Technologies AG, 81669 München (DE)
(72) Erfinder: Sichert, Christian, 81827 München (DE)
(74) Vertreter: Zedlitz, Peter, Dipl.-Inf.

(56) Entgegenhaltungen:
- EP-A- 0 555 075
- EP-A- 0 621 694
- US-A- 5 469 080

## Beschreibung

Die Erfindung betrifft einen Eingangsverstärker mit einseitiger Versorgungsstromabschaltung für Eingangssignale mit steilen Flanken wie er im Oberbegriff des Anspruchs 1 beschrieben ist.

CMOS-Eingangsverstärker sind seit längerem bekannt und werden für die vielfältigsten Schaltungszwecke eingesetzt. So ist ein Eingangsverstärker der eingangs genannten Art beispielsweise in dem Fachbuch "CMOS-Analog Circuit Design" von P.E. Allen und D.R. Holberg, auf Seite 381 beschrieben.

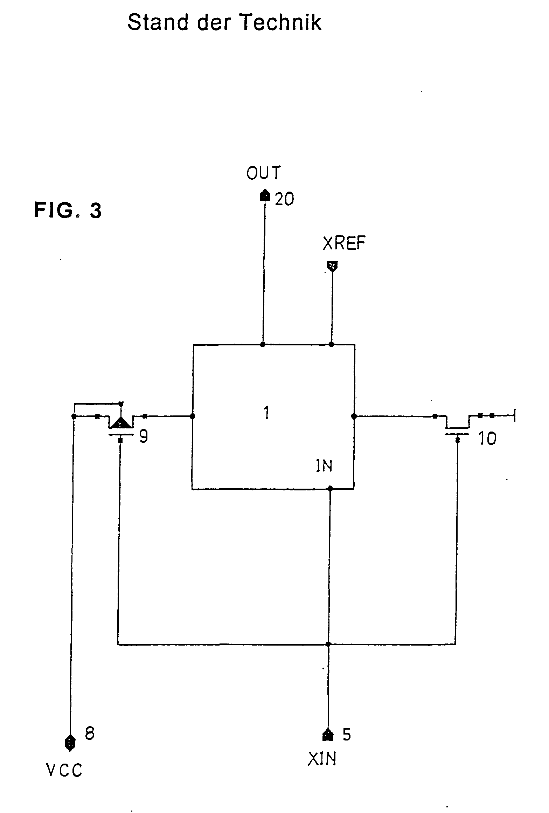

Fig. 3 zeigt einen solchen bekannten Eingangsverstärker aus einem Differenzverstärker 1, einem P-Kanal-MOS-Transistor 9 und einem N-Kanal-MOS-Transistor 10. Gates der Transistoren 9, 10 und ein Eingang IN des Differenzverstärkers 1 sind mit einem Eingangsanschluß 5 verbunden, an welchem ein Eingangssignal XIN liegt, während die Source-Drain-Strecke des Transistors 9 mit einem Anschluß 8 für eine Betriebsspannung VCC verbunden ist. Außerdem ist der Differenzverstärker 1 mit einer Bezugsspannung XREF beaufschlagt und mit einem Ausgangsanschluß 20 zur Abgabe eines Ausgangssignals OUT verbunden.

Verwendungsmöglichkeiten für solche bekannte Eingangsverstärker sind beispielsweise LVTTL-Schaltungen (LVTTL = Low Voltage-Transistor-Transistor-Logik) und SSTL-Logik-Schaltungen (SSTL = Stub-Series-Terminated-Logic). In LVTTL-Logik-Schaltungen treten Spannungsanstiegs- und -abfallflanken von etwa 0,8 V bis 2,0 V auf, während die SSTL-Logik-Schaltungen entsprechende Anstiegs- und -abfallflanken von etwa 400 mV um einen Referenzwert haben.

In beiden Logikschaltungen, also den LVTTL-Logik-Schaltungen und den SSTL-Logik-Schaltungen, sind die Spannungsabfallflanken sehr steil, so daß entsprechend schnelle Eingangsflanken vorliegen. Sind nun auf einem Chip zahlreiche Eingangsverstärker vorgesehen, so sollen in einem stromsparenden Betriebsmodus nur die Schaltungen tatsächlich aktiv sein, die angesteuert sind.

Es hat sich nun aber gezeigt, daß bei steilen Flanken der Eingangssignale ein entsprechendes Abschalten des Eingangsverstärkers nicht sicher gewährleistet ist.

Um dieses Problem zu lösen, wurde bisher daran gedacht, Stromspiegelschaltungen oder asymmetrische Eingangsverstärker einzusetzen. Stromspiegelschaltungen verbrauchen aber relativ viel Strom, während asymmetrische Eingangsverstärker in der Symmetrie ihres Schaltverhaltens nachteilhaft sind.

Es ist daher **Aufgabe** der vorliegenden Erfindung, einen Eingangsverstärker mit einseitiger Versorgungsstromabschaltung zu schaffen, der auch bei schnellen Eingangsflanken ein zuverlässiges Schalten zu gewährleisten vermag.

Diese Aufgabe wird mit den kennzeichnenden Merkmalen des Anspruchs 1 gelöst.

In bevorzugter Weise ist der Transistor ein erster MOS-Transistor eines ersten Leitfähigkeitstyps. Dann wird für die Einrichtung ein weiterer MOS-Transistor des zweiten, zum ersten entgegengesetzten, Leitfähigkeitstyps verwendet, der eine höhere Einsatzspannung als diejenige des ersten MOS-Transistors hat. Der weitere MOS-Transistor liegt mit seiner Source-Drain-Strecke zwischen den Gates der Stromspiegel-Transistoren des Eingangsverstärkers und ist an seinem Gate mit den Sources beziehungsweise Drains dieser Transistoren verbunden oder mit der Betriebsspannung beaufschlagt.

Nachfolgend wird die Erfindung anhand der Zeichnung näher erläutert. Es zeigen:
- Fig. 1: ein Schaltbild des erfindungsgemäßen Eingangsverstärkers;
- Fig. 2: ein Detailschaltbild des Eingangsverstärkers von Fig. 1, und
- Fig. 3: ein Schaltbild eines herkömmlichen Eingangs-verstärkers.

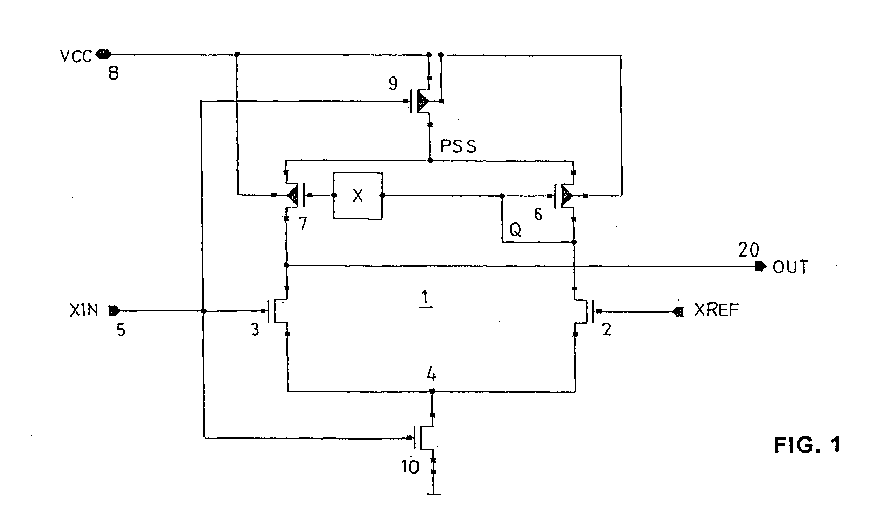

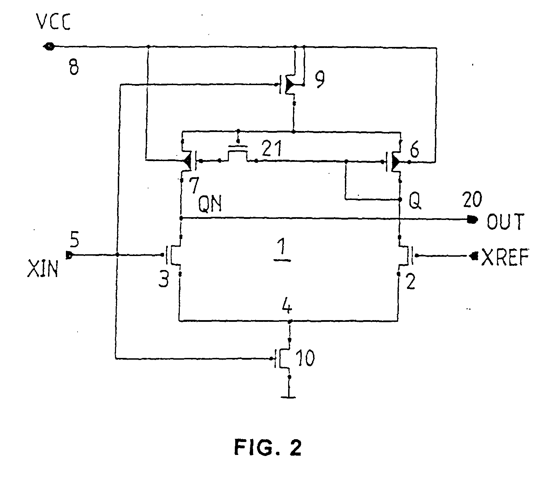

Fig. 3 ist bereits eingangs erläutert worden. In den Fig. 1 und 2 sind einander entsprechende Bauteile mit den gleichen Bezugszeichen wie in Fig. 3 versehen.

Ein Differenzverstärker 1 besteht aus einem an seinem Gate mit einer Bezugsspannung XREF beaufschlagten N-Kanal-MOS-Transistor 2 und einem bezüglich eines Knotens 4 hierzu symmetrisch liegenden N-Kanal-MOS-Transistor 3. Einem Eingangsanschluß 5, der mit Gate des Transistors 3 verbunden ist, ist ein Eingangssignal XIN zugeführt. Sources beziehungsweise Drains der Transistoren 2, 3 sind mit Stromspiegel-P-Kanal-MOS-Transistoren 6, 7 verbunden, deren Substrate jeweils mit einer Betriebsspannung VCC beaufschlagt sind, die über einen Anschluß 8 zugeführt ist. Diese Betriebsspannung VCC liegt auch an einem P-Kanal-MOS-Transistor 9, dessen Gate das Eingangssignal XIN zugeführt ist. Die Source beziehungsweise Drain des N-Kanal-MOS-Transistors 10 ist mit dem Knoten 4 verbunden ist und an dessen Gate liegt das Eingangssignal XIN von dem Eingangsanschluß. Gate des Transistors 6 ist mit einem Knoten Q zwischen den Transistoren 2 und 6 verbunden Außerdem ist ein Knoten QN zwischen den Transistoren 3 und 7 mit einem Ausgangsanschluß 20 zur Lieferung eines Ausgangssignals OUT verbunden.

Die Transistoren 9, 10 dienen dazu, einen bei hohen Spannungshüben im Differenzverstärker 1 fließenden Querstrom abzuschalten.

Die Transistoren 3, 7 sind symmetrisch zu den Transistoren 2, 6. Der Stromspiegel aus den Transistoren 6 und 7 kann auch mit N-Kanal-MOS-Transistoren realisiert werden. Analog können die Eingangstransistoren 2, 3 P-Kanal-MOS-Transistoren sein.

Am Eingangsanschluß 5 liegt beispielsweise ein Eingangssignal, das in der LVTTL-Logik steil von etwas über 2,0 V auf unter 0,8 V abfällt.

Eine "Hoch-Niedrig-Spannungsflanke" der genannten Art schaltet bei einer Schaltung, wie diese oben bisher beschrieben ist, den Transistor 10 ab, wodurch der Knoten Q in seiner Spannung durch den Transistor 6 nach oben gezogen wird. Hierdurch wird wiederum auch der Transistor 7 abgeschaltet, der an sich aber den Knoten QN spannungsmäßig nach oben ziehen sollte. Mit anderen Worten, der bisher beschriebene Eingangsverstärker arbeitet bei Eingangssignalen mit steilen Flanken nicht zufriedenstellend.

Um ein solches befriedigendes Arbeiten auch bei derartigen Eingangssignalen mit steilen Flanken zu gewährleisten, hat der erfindungsgemäße Eingangsverstärker zusätzlich noch eine Einrichtung X (vergleiche Fig. 1), die ein vollständiges Abschalten des Transistors 7 verhindert und beispielsweise (vergleiche Fig. 2) aus einem N-Kanal-MOS-Transistor 21 besteht, der mit seiner Source-Drain-Strecke zwischen den Gates der Transistoren 6, 7 beziehungsweise dem Knoten Q und dem Gate des Transistors 7 liegt und mit seinem Gate an den Knoten zwischen den Source-Drain-Strecken der Transistoren 6, 7 und des Transistors 9 angeschlossen oder mit der Betriebsspannung VCC beaufschlagt ist.

Infolge des Transistors 21 nimmt bei einem Eingangssignal mit einer steilen Hoch-Niedrig-Flanke bei dem so aufgebauten erfindungsgemäßen Eingangsverstärker der Knoten Q die VCC-Einsatzspannung des Transistors 6 an , so daß der Transistor 6 ausgeschaltet wird. Da aber die Einsatzspannung des Transistors 21 höher als die Einsatzspannung des Transistors 6 ist, was durch den "Bulk-Effekt" erreicht werden kann, wird hierdurch ein Ausschalten des Transistors 7 verhindert, wodurch der Knoten QN nach oben gezogen wird.

Auf diese Weise ermöglicht der erfindungsgemäße Eingangsverstärker ein Schalten von Signalen mit sehr schnellen Flanken, so daß zuverlässig ein Abschalten vorgenommen werden kann. Der Schaltungsaufwand, der zusätzlich zu dem bestehenden Eingangsverstärker erforderlich ist, ist äußerst gering, da lediglich der weitere Transistor 21 benötigt wird.

## Patentansprüche

1. Eingangsverstärker mit einseitiger Versorgungsstromabschaltung für Eingangssignale (XIN) mit steilen Flanken, mit einem Transistor (10) und einem Differenzverstärker (1), der einen Stromspiegel (6, 7) mit einem Eingangs- und einem Ausgangstransistor enthält, wobei der Transistor (10) beim Anliegen eines Eingangssignals mit einer Flanke in einer ersten Richtung die Verbindung des Differenzverstärkers mit einem ersten Pol der Betriebsspannung unterbricht und wobei eine Elektrode (QN) des Ausgangstransistors (7) mit einem Ausgang (OUT) des Eingangsverstärkers verbunden ist,
**gekennzeichnet durch**
eine Einrichtung (X, 21), die ein vollständiges Abschalten des Ausgangstransistors (7) verhindert, wenn der Eingangstransistor (6) nach dem Anliegen eines Eingangssignals mit einer Flanke in der ersten Richtung abschaltet, so dass die Elektrode (QN) auf einen zweiten Pol (VCC) der Betriebsspannung des Eingangsverstärkers gezogen wird.

2. Eingangsverstärker nach Anspruch 1,
**dadurch gekennzeichnet,**
**daß** der Ausgangstransistor (7) ein erster MOS-Transistor eines ersten Leitfähigkeitstyps ist, und daß die Einrichtung einen weiteren MOS-Transistor (21) des zweiten Leitfähigkeitstyps mit höherer Einsatzspannung als diejenige des ersten MOS-Transistors (7) aufweist.

3. Eingangsverstärker nach Anspruch 2,
**dadurch gekennzeichnet,**
**daß** der Eingangstransistor (6) des Stromspiegels ein zweiter MOS- Transistor des ersten Leitfähigkeitstyps ist und
**daß** der weitere MOS-Transistor (21) mit seiner Source-Drain-Strecke zwischen den Gates der MOS-Transistoren (6, 7) des Stromspiegels liegt und an seinem Gate mit den Sources beziehungsweise Drains dieser Transistoren (6, 7) verbunden oder mit dem Potential des zweiten Pols (VCC) der Betriebsspannung beaufschlagt ist.

## Claims

1. Input amplifier having single-ended supply current switch-off for input signals (XIN) having steep edges, having a transistor (10) and a differential amplifier (1), which contains a current mirror (6, 7) with an input transistor and an output transistor, the transistor (10), given the presence of an input signal having an edge in a first direction, interrupting the connection of the differential amplifier to a first pole of the operating voltage and an electrode (QN) of the output transistor (7) being connected to an output (OUT) of the input amplifier,
**characterized by**
a device (X, 21), which prevents a complete switch-off of the output transistor (7) if the input transistor (6) switches off after the presence of an input signal having an edge in the first direction, so that the electrode (QN) is pulled to a second pole (VCC) of the operating voltage of the input amplifier.

2. Input amplifier according to Claim 1,
**characterized**
**in that** the output transistor (7) is a first MOS transistor of a first conductivity type, and in that the device has a further MOS transistor (21) of the second conductivity type having a higher threshold voltage than that of the first MOS transistor (7).

3. Input amplifier according to Claim 2,
**characterized in that**
the input transistor (6) of the current mirror is a second MOS transistor of the first conductivity type, and **in that** the further MOS transistor (21) is connected by its source-drain path between the gates of the MOS transistors (6, 7) of the current mirror and at its gate is connected to the sources or respectively drains of these transistors (6, 7) or has applied to it the potential of the second pole (VCC) of the operating voltage.

## Revendications

1. Amplificateur d'entrée à déconnexion d'un seul côté du courant d'alimentation pour des signaux (XIN) d'entrée à fronts raides, comportant un transistor (10) et un amplificateur (1) différentiel qui contient un miroir (6, 7) de courant ayant un transistor d'entrée et un transistor de sortie, le transistor (10) interrompant, lorsque s'applique un signal d'entrée ayant un front dans une première direction, la liaison de l'amplificateur différentiel avec un premier pôle de la tension de service et une électrode (QN) du transistor (7) de sortie étant reliée à une sortie (OUT) de l'amplificateur d'entrée, **caractérisé par** un dispositif (X, 21) qui empêche une déconnexion totale du transistor (7) de sortie si le transistor (6) d'entrée déconnecte après l'application d'un signal d'entrée ayant un front dans une première direction, si bien que l'électrode (QN) est attirée sur un deuxième pôle (VCC) de la tension de service de l'amplificateur d'entrée.

2. Amplificateur d'entrée suivant la revendication 1, **caractérisé en ce que** le transistor (7) de sortie est un premier transistor MOS d'un premier type de conductivité et **en ce que** le dispositif comporte un transistor (21) MOS supplémentaire du second type de conductivité à tension de passage à l'état passant plus grande que celle du premier transistor (7) MOS.

3. Amplificateur d'entrée suivant la revendication 2, **caractérisé en ce que** le transistor (6) d'entrée du miroir de courant est un deuxième transistor MOS du premier type de conductivité et **en ce que** le transistor (21) MOS supplémentaire se trouve par sa section source-drain entre les grilles des transistors (6, 7) MOS du miroir de courant et, à sa grille, est relié aux sources et drains de ces transistors (6, 7) ou alimenté en le potentiel du deuxième pôle (VCC) de la tension de service.
